# EUROPÄISCHE PATENTSCHRIFT

(11) **EP 3 113 220 B1**
(45) Veröffentlichungstag und Bekanntmachung des Hinweises auf die Patenterteilung: **27.03.2019**
(21) Anmeldenummer: 16178495.4
(22) Anmeldetag: 06.11.2014
(51) Int. Cl.: H01L 23/34, H01L 23/473, H01L 23/367, F28F 3/02, H01L 21/48, H05K 7/20, F28F 13/08, H01L 23/467

(54) **KÜHLKÖRPER**
COOLING ELEMENT
DISSIPATEUR THERMIQUE

(30) Priorität: 06.11.2013 DE 202013104990 U
(43) Veröffentlichungstag der Anmeldung: 04.01.2017
(62) Teilanmeldung aus: 14191989.4
(73) Patentinhaber: AKG Thermotechnik International GmbH & Co. KG, 34369 Hofgeismar (DE)
(72) Erfinder: KOZICA, Michael, 34376 Immenhausen (DE); WIELEKE, Fabian, 34246 Vellmar (DE); ZINN, Thomas, 34125 Kassel (DE)
(74) Vertreter: Dantz, Jan Henning

(56) Entgegenhaltungen:
- EP-A2- 0 206 980
- EP-A2- 1 378 940
- WO-A1-02/070977
- WO-A1-2010/006875
- CN-A- 102 231 370
- DE-A1- 3 415 554
- DE-U1- 20 309 856
- JP-A- 2013 125 752
- US-A1- 2005 241 801
- US-A1- 2010 236 755

## Beschreibung

Die vorliegende Erfindung betrifft einen Kühlkörper für mindestens ein zu kühlendes Bauelement, insbesondere ein Halbleiterbauelement, gemäß dem Oberbegriff des Anspruchs 1.

Gattungsgemäße Kühlkörper zur Kühlung von insbesondere elektronischen Hochleistungsbauteilen wie beispielsweise IGBT-Baugruppen für Stromrichter, beispielsweise bekannt aus der DE 10 2006 019 376 A1, der DE 43 22 647 A1, der EP 1 378 940, der WO 2010/006875 oder der DE 93 04 128 U1 dienen dazu, die von diesen Bauelementen erzeugte Wärme abzuleiten und dadurch die Bauelemente zu kühlen.

Die Kühlkörper bestehen dabei in der Regel aus einer Grundplatte, auf der eines oder mehrere dieser Bauteile flächig aufgebracht sind, und einer dieser Bauelementfläche abgewandten Kühlkörperfläche, von der sich Kühlluftkanäle bildende Kühlrippen weg erstrecken. Diese Kühlrippen sind dabei in einer Variante in Nuten einer beispielsweise als Strangpressprofil ausgebildeten Grundplatte eingelassen, so dass die von den Bauteilen erzeugte Wärme durch die Grundplatte in die Kühlrippen geleitet wird und die Kühlrippen ihrerseits unter Ausbildung der oben genannten Kühlluftkanäle bei Durchleitung von Kühlluft durch den Kühlkörper diese Wärme an die durchgeleitete Kühlluft abgeben.
Zur Erzielung einer möglichst hohen Leistung dieser Kühlkörper, sprich einer möglichst effektiven Wärmeabfuhr, ist zum einen eine hohe Rippendichte mit möglichst dünnwandigen Rippenkörper erwünscht, zum zweiten sollte der Druckverlust der Kühlluft beim Durchleiten durch den Kühlkörper möglichst gering sein. Schließlich sollte die Kühlleistung des Kühlkörpers in KühlluftStrömungsrichtung durch den Kühlkörper möglichst konstant sein, um auch bei beispielsweise in Kühlluftströmungsrichtung hintereinander gebauten zu kühlenden Bauteilen auch die hinteren Bauteile noch hinreichend kühlen zu können.

Aufgabe der vorliegenden Erfindung ist es, einen Kühlkörper bereitzustellen, mit dem die oben genannten Probleme möglichst effektiv und kostengünstig gelöst werden.

Diese Aufgabe wird durch einen Kühlkörper mit den Merkmalen des Anspruchs 1 gelöst.

Der mit Anspruch 1 beanspruchte Aufbau eines Kühlkörpers weist eine erste Grundplatte mit einer Bauelementfläche auf, auf der das mindestens eine zu kühlende Bauelement befestigbar ist, sowie eine umseitige Kühlkörperoberfläche sowie mehrere Kühlluftkanäle bildende Kühlrippen, die mit jeweiligen ersten Enden an der Kühlkörperfläche der ersten Grundplatte befestigt sind.

Die ersten Enden der Kühlrippen sind dabei in rillenförmigen Aufnahmen eines auf der Kühlkörperfläche der ersten Grundplatte beidseitig lotplattierten Bleches aufgenommen, wobei die Kühlrippen, das Blech und die erste Grundplatte miteinander verlötet sind.

Ein in dieser Weise ausgebildeter Kühlkörper zeichnet sich durch seine kostengünstige Herstellbarkeit aus. Außerdem steht bei einem derart ausgebildeten lotplattierten Blech genügend Verbindungsfläche zur Verfügung, um eine zuverlässige Bindung zwischen den Kühlrippen, dem Blech und der Grundplatte zu gewährleisten.

Insbesondere ist auch eine Verbindung der Kühlrippen mit der Grundplatte bei Grundplatten mit geringfügig unebenen Oberflächen möglich.

Außerdem kann bei derart ausgebildeten Kühlkörpern das sehr kostenintensive Einbringen von Nuten in die Grundplatte vermieden werden. Solche Grundplatten könnten prinzipiell auch im Strangpressverfahren hergestellt werden, was aber zu hohen Werkzeugkosten führt. Außerdem ist dieses Verfahren relativ unflexibel, da die Kühlrippendicke und -teilung sowie die Breite des Kühlkörpers selbst feststehen.

Ein weiteres Problem bei diesem Verfahren besteht darin, Lot in einer geeigneten Menge an die Verbindungsstellen zu dosieren. Beidseitig plattierte Rippen enthalten dabei zu viel Lot. Problematisch an einer solchen Lotpaste ist dabei, dass beim Löten Binder ausgast und die Lötvorrichtung verschmutzt, was mit zusätzlichen Kosten zu deren Beseitigung einhergeht.

Der Kühlkörper gemäß Anspruch 1 ist bevorzugt mit einem Blech versehen, das mit zur Kühlkörperoberfläche der ersten Grundplatte offenen Kanälen zwischen den rillenförmigen Aufnahmen ausgebildet ist, die im Betrieb mit einem Kältemittel gefüllt sind. Mithilfe eines solchen in den rillenförmigen Aufnahmen zirkulierenden Kältemittels ist eine nochmals verbesserte Verteilung der abzuführenden Wärme ermöglicht.

In einer besonders bevorzugten Ausführungsvariante des erfindungsgemäßen Kühlkörpers sind auch die zweiten Enden der Kühlrippen in rillenförmigen Aufnahmen eines auf der Kühlkörperfläche einer zweiten Grundplatte beidseitig lotplattierten Bleches aufgenommen, wobei die Kühlrippen, das Blech und die zweite Grundplatte miteinander verlötet sind.

Die beiden Grundplatten sind dabei bevorzugt durch zwei Rohr- oder Schlauchverbindungen, die einen Kältemitteltransport ermöglichen, miteinander verbunden. Dabei wird in einem oberen Bereich das Kältemittel kondensiert und Wärme an die Kühlrippen übertragen. Da im oberen Bereich Wärme von beiden Seiten in die Kühlrippen übertragen wird, wird der Rippenwirkungsgrad wesentlich größer und die Wärmeübertragung signifikant gesteigert.

Denkbar ist auch in einer weiteren Ausführungsvariante, die Kühlrippen nicht über die gesamte Länge des Kühlkörpers auszubilden, sondern nur im Bereich, in dem Kondensation stattfindet, beispielsweise über die Hälfte der Länge des Kühlkörpers.

Nachfolgend werden Ausführungsbeispiele der Erfindung anhand der beiliegenden Zeichnungen näher erläutert. Es zeigen:
- Figur 1: eine perspektivische Ansicht einer Ausführungsvariante eines erfindungsgemäßen Kühlkörpers mit über Bleche mit einer Grundplatte verbundenen Kühlrippen,
- Figur 2: eine weitere perspektivische Ansicht der Ausführungsvariante eines Kühlkörpers gemäß Figur 1 mit zusätzlich dargestellten Nuten des Grundkörpers und
- Figur 3: eine nochmal alternative Ausführungsvariante eines erfindungsgemäßen Kühlkörpers mit auf einer Grundplatte des Kühlkörpers aufgebrachten zu kühlendem Bauteil und zwei Grundplatten.

In der nachfolgenden Figurenbeschreibung beziehen sich Begriffe wie oben, unten, links, rechts, vorne, hinten usw. ausschließlich auf die in den jeweiligen Figuren ausgewählte beispielhafte Darstellung und Position des Kühlkörpers, der Grundplatte, Kühlrippen, Kühlluftkanäle, Stege und dergleichen. Diese Begriffe sind nicht einschränkend zu verstehen, d. h., durch verschiedene Arbeitsstellungen oder die spiegelsymmetrische Auslegung oder dergleichen können sich diese Bezüge ändern.

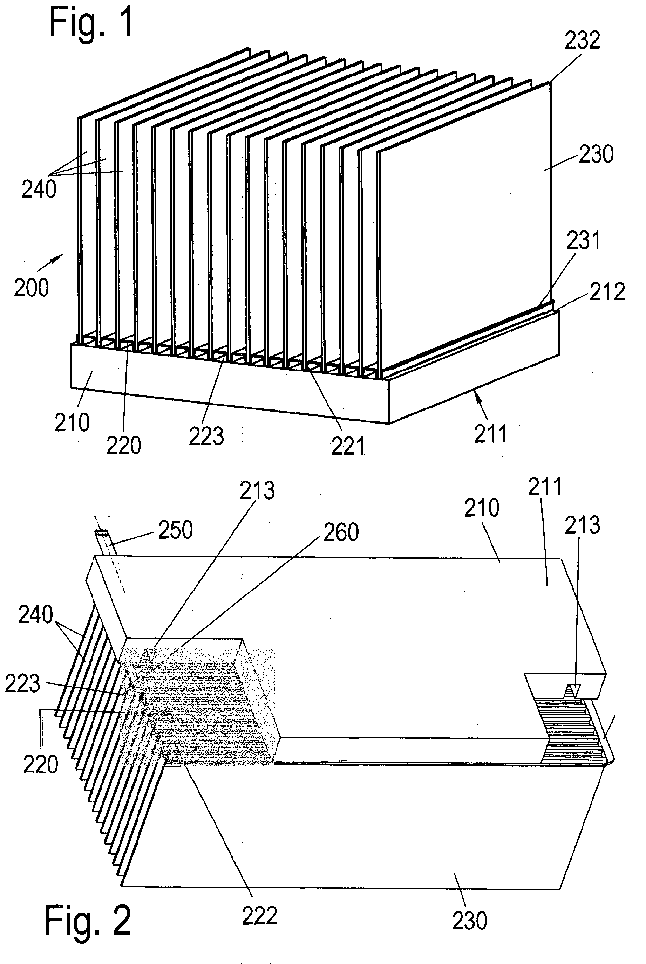

Bei der in den Figuren 1 bis 3 gezeigten Ausführungsvarianten des Kühlkörpers sind Kühlrippen 230 mit ihren ersten Enden 231 in rillenförmigen Aufnahmen 221 eines auf einer Kühlkörperfläche 212 einer ersten Grundplatte 210 beidseitig lotplattierten Bleches 220 aufgenommen.

Die Kühlrippen 230, das Blech 220 und die erste Grundplatte 210 sind dabei miteinander verlötet, insbesondere induktionsverlötet.

Das Blech weist dabei zur Kühlkörperfläche 212 der ersten Grundplatte 210 offene Kanäle 223 zwischen den rillenförmigen Aufnahmen 221 zur Aufnahme der Kühlrippen 230 auf. Diese Kanäle 223 sind im Betrieb des Kühlkörpers mit einem Kältemittel gefüllt, das in den Kanälen 223 aufgrund von Dichteunterschieden, hervorgerufen durch mit unterschiedlichen Temperaturen einhergehenden Aggregatszustandsänderungen des Kältemittels, zirkuliert. Dadurch ist eine nochmals verbesserte Abfuhr der Abwärme des zu kühlenden Bauteils 1 ermöglicht.

Als Kältemittel wird dabei ein Fluid bezeichnet, das bei niedriger Temperatur und niedrigem Druck Wärme aufnimmt und bei höherer Temperatur und höherem Druck Wärme abgibt. Solche Kältemittel werden beispielsweise bei Wärmerohren (auch "Heatpipes" genannt) oder in Kompressionswärmepumpen eingesetzt.

Das Blech 220 ist dabei bevorzugt lamellenartig verformt, insbesondere gestanzt oder gewalzt.

Die Zuführung des Kältemittels erfolgt dabei bevorzugt über eine in der Grundplatte 210 zu dem Blech 220 hin offenen Nut 213, die sich quer zu den Kanälen 223 des Bleches 220 erstreckt.

Wie in Figur 2 gezeigt, ist die Nut 213 dabei an einer Seitenkante der Grundplatte 210 mit einem Zuführelement, beispielsweise einem Rohrstück oder einem Schlauch 250 verbunden, durch dass das Kühlmittel in die Nut 213 und die Kanäle 223 zu beziehungsweise abgeführt werden kann. Die Kanäle 223 sind dabei stirnseitig bevorzugt durch ein sich an den Stirnkanten des Bleches 220 entlang erstreckendes Dichtelement 260 abgedichtet. Die Abdichtung erfolgt dabei bevorzugt durch Verschweißen. Dementsprechend ist das Dichtelement 260 in der in Figur 6 gezeigten Ausführungsvariante als Schweißnaht ausgebildet

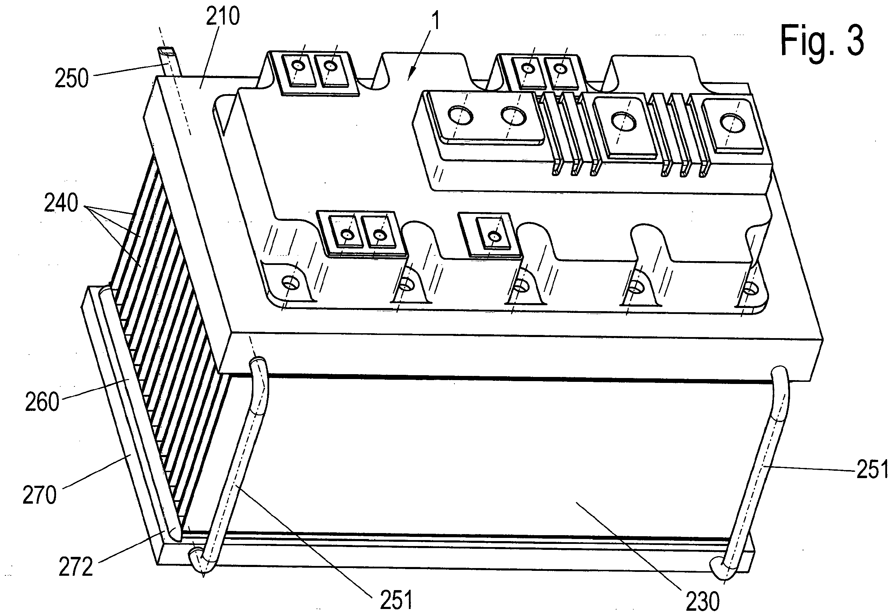

Figur 3 zeigt eine Ausführungsvariante eines erfindungsgemäßen Kühlkörpers mit zwei Grundplatten 210, 270, wobei auf der ersten Grundplatte 210 der zu kühlende Körper 1 montiert ist.

Die beiden Grundplatten 210, 270 sind dabei durch ein Rohrstück 251 miteinander verbunden. Diese Rohrstücke 251 münden dabei in die Nuten 213 der Grundplatten 210, 270. Durch diese Verbindungselemente 251 kann das Kältemittel von der ersten Grundplatte in die zweite Grundplatte 270 fließen.

Im oberen Bereich des Kühlkörpers wird dabei das Kältemittel in den Kanälen 223 kondensieren und so Wärme an die Kühlrippen 230 übertragen. Durch die Wärmeübertragung von beiden Seiten an die Kühlrippen wird der Rippenwirkungsgrad deutlich erhöht und dadurch die Wärmeübertragung signifikant gesteigert.

Um in allen Kanälen 223 eine gleichmäßige Befüllung, insbesondere einen gleichmäßigen Flüssigkeitsstand aufrechtzuerhalten und im Betrieb gegebenenfalls eine innere Umwälzung des Kältemittels zu gewährleisten, sind in den Grundplatten 210, 270 bevorzugt zwei solcher Nuten 213 vorgesehen. Die beiden Nuten 213 sind dabei bevorzugt möglichst weit voneinander beabstandet.

In einer denkbaren weiteren möglichen Ausgestaltung eines solchen Kühlkörpers erstrecken sich die Kühlrippen 230 nicht über die gesamte Länge des Kühlkörpers 2, sondern erstrecken sich nur in einem Bereich, an dem eine Kondensation des Kältemittels stattfindet, insbesondere über die Hälfte der Länge des Kühlkörpers 2. Der Kühlkörper 2 kann dabei bevorzugt entsprechend der anhand von Figur 2 beschriebenen Ausführungsvariante ausgeführt sein.

### Bezugszeichenliste

- 1: Bauelement

- 210: Grundplatte
- 212: Kühlkörperfläche
- 213: Nut

- 220: Blech
- 221: Aufnahme
- 223: offene Kanäle

- 230: Kühlrippe
- 231: erstes Ende

- 250: Schlauch
- 251: Rohrstück

- 260: Dichtelement
- 270: Grundplatte

- x: Kühlluftströmungsrichtung

## Patentansprüche

1. Kühlkörper (200) für mindestens ein zu kühlendes Bauelement (1), insbesondere ein Halbleiterbauelement, aufweisend eine erste Grundplatte (210) mit einer Bauelementfläche (211), auf der das mindestens eine zu kühlende Bauelement (1) befestigbar ist, und einer umseitigen Kühlkörperfläche (212) sowie mehrere Kühlluftkanäle (240) bildende Kühlrippen (230), die mit jeweiligen ersten Enden (231) an der Kühlkörperfläche (212) der ersten Grundplatte (210) befestigt sind, **dadurch gekennzeichnet, dass** die ersten Enden (231) der Kühlrippen (230) in rillenförmigen Aufnahmen (221) eines auf der Kühlkörperfläche (212) der ersten Grundplatte (210) beidseitig lotplattierten Bleches (220) aufgenommen sind, wobei die Kühlrippen (230), das Blech (220) und die erste Grundplatte (210) miteinander verlötet sind.

2. Kühlkörper (200) nach Anspruch 1, **dadurch gekennzeichnet, dass** das Blech (220) mit zur Kühlkörperfläche (212) der ersten Grundplatte (210) offenen Kanälen (223) zwischen den rillenförmigen Aufnahmen (221) ausgebildet ist, die im Betrieb mit einem Kältemittel gefüllt sind.

3. Kühlkörper (200) nach Anspruch 1 oder 2, **dadurch gekennzeichnet, dass** zweite Enden (232) der Kühlrippen (230) in rillenförmigen Aufnahmen (221) eines auf der Kühlkörperfläche (272) einer zweiten Grundplatte (270) beidseitig lotplattierten Bleches (220) aufgenommen sind, wobei die Kühlrippen (230), das Blech (220) und die zweite Grundplatte (270) miteinander verlötet sind.

## Claims

1. Heat sink (200) for at least one component (1) to be cooled, in particular a semiconductor component, said heat sink having a first base plate (210) with a component surface (211), to which the at least one component (1) to be cooled can be fastened, and with a heat sink surface (212) on the reverse side, as well as a plurality of cooling fins (230) which form cooling air channels (240) and which are fastened by respective first ends (231) to the heat sink surface (212) of the first base plate (210), **characterized in that** the first ends (231) of the cooling fins (230) are received in groove-shaped recesses (221) of a metal sheet (220) that is solder-plated on both sides onto the heat sink surface (212) of the first base plate (210), the cooling fins (230), the metal sheet (220) and the first base plate (210) being soldered to one another.

2. Heat sink (200) according to claim 1, **characterized in that** the metal sheet (220) is configured with channels (223) between the groove-shaped recesses (221), said channels being open towards the heat sink surface (212) of the first base plate (210) and being filled with a coolant during operation.

3. Heat sink (200) according to claim 1 or 2, **characterized in that** second ends (232) of the cooling fins (230) are received in groove-shaped recesses (221) of a metal sheet (220) that is solder-plated on both sides onto the heat sink surface (272) of a second base plate (270), the cooling fins (230), the metal sheet (220) and the second base plate (270) being soldered to one another.

## Revendications

1. Dissipateur thermique (200) pour au moins un composant à refroidir (1), en particulier un composant à semiconducteurs, présentant une première plaque de base (210) avec une surface de composant (211) sur laquelle ledit au moins un composant à refroidir (1) peut être fixé et une surface de dissipateur thermique (212) au verso ainsi que des ailettes de refroidissement (230) formant plusieurs canaux d'air de refroidissement (240), qui sont fixées à des premières extrémités respectives (231) à la surface de dissipateur thermique (212) de la première plaque de base (210), **caractérisé en ce que** les premières extrémités (231) des ailettes de refroidissement (230) sont logées dans des logements (221) en forme de rainure d'une tôle (220) qui est plaquée par brasage des deux côtés sur la surface de dissipateur thermique (212) de la première plaque de base (210), les ailettes de refroidissement (230), la tôle (220) et la première plaque de base (210) étant brasées ensemble.

2. Dissipateur thermique (200) selon la revendication 1, **caractérisé en ce que** la tôle (220) est formée avec des canaux (223) ouverts vers la surface de dissipateur thermique (212) de la première plaque de base (210) entre les logements (221) en forme de rainure, lesquels sont remplis d'un fluide réfrigérant pendant le fonctionnement.

3. Dissipateur thermique (200) selon la revendication 1 ou 2, **caractérisé en ce que** les deuxièmes extrémités (232) des ailettes de refroidissement (230) sont logées dans des logements (221) en forme de rainure d'une tôle (220) plaquée par brasage des deux côtés sur la surface de dissipateur thermique (272) d'une deuxième plaque de base (270), les ailettes de refroidissement (230), la tôle (220) et la deuxième plaque de base (270) étant brasées ensemble.
